Europäisches Patentamt

European Patent Office

Office européen des brevets

(19)

(11) Publication number: **0 042 577**

**B1**

(12) **EUROPEAN PATENT SPECIFICATION**

(45) Date of publication of patent specification: **04.04.84**

(21) Application number: **81104633.3**

(22) Date of filing: **16.06.81**

(51) Int. Cl.³: **F 24 J 3/02,** F 03 G 7/02,
H 01 L 31/04

(54) **Radiant energy conversion.**

(30) Priority: **20.06.80 US 161982**

(43) Date of publication of application:
**30.12.81 Bulletin 81/52**

(45) Publication of the grant of the patent:
**04.04.84 Bulletin 84/14**

(84) Designated Contracting States:
**DE FR GB**

(56) References cited:
CH - A - 102 488
GB - A - 1 515 763
US - A - 3 029 596
US - A - 3 596 034
US - A - 3 929 510
US - A - 4 090 359
US - A - 4 146 057

PROCEEDING OF THE IEEE, vol. 67, no. 3,
March,1979 R.M. SWANSON "A proposed
thermophotovoltaic solar conversion system"

(73) Proprietor: **International Business Machines
Corporation
Old Orchard Road
Armonk, N.Y. 10504 (US)**

(72) Inventor: **Woodall, Jerry McPherson
336 Cherry Street
Bedford Hills New York 10507 (US)**

(74) Representative: **Atchley, Martin John Waldegrave
IBM United Kingdom Patent Operations Hursley
Park
Winchester, Hants, SO21 2JN (GB)**

Courier Press, Leamington Spa, England.

# Radiant energy conversion

The invention relates to the conversion of radiant into electrical energy. Energy available in varying intensity and duration is frequently desired for use in a different form and at a different rate. It is particularly useful in steady electrical form but at this state of the art conversion capability is limited. The major radiant energy source is the sun which emits a broad band of wavelengths but is of intermittent duration. Other sources such as industrial operations may have radiant energy and thermal energy available as a by-product. Such sources usually have narower bands and different durations and wavelengths. Most thermal energy utilization operations such as space heating has excess capacity and losses that could be captured in another energy form.

The desirability of energy storage for load leveling purposes has been set forth in *Solar Energy Thermal Processes,* published by Wiley, New York, pages 231 to 235 wherein current techniques such as using the latent heat of melting of salts are seen to be limited by the amount of energy that can be stored and by the rate at which it can be removed.

An effective method of using radiant or thermal energy is through conversion to electrical energy. At this time however, there is substantial room for improvement in the conversion efficiency. Further, the generally varying intensity and intermittent nature of the sources are usually incompatible with most electrical energy applications and distribution systems which usually require a steady supply.

The improvement efforts in conversion to electrical energy of the radiant energy sources such as solar energy and the energy in a fuel cell using a photo-electric converter, primarily involve sophisticated solid state physics efforts at improving the wavelength range and overall efficiency of the photo-voltaic cell. It is well known at this time that a p-n homojunction photovoltaic solar cell has a limit conversion efficiency of about 26% for converting sunlight, which is a broad band radiation source, into electricity and much room for improvement is available with such devices.

There have been some other efforts in the art to convert radiant energy to steady electrical energy.

US—A—3 929 510 discloses, in solar energy conversion, the use of a rare earth metal converter before the photovoltaic cell to improve the spectral match. US—A—3 433 676 and US—A—4 090 359 disclose, in industrial energy conversion, the conversion of energy from continuous heat sources such as a jet engine and flame source to improve efficiency of the electrical output.

In the Proceedings of the IEEE, Vol. 67, No. 3, March 1979, at page 446 is disclosed a proposed thermophotovoltaic solar energy conversion system in which light is concentrated upon a hemispherical radiator of unspecified refractory material reaching a temperature of 2000 to 2400K. The radiator radiates energy onto a hemispherical photo-voltaic cell which converts it into electricity. There is no suggestion of heat storage for controlled emission.

The present invention involves energy conversion by retention of thermal energy supplied by radiant energy in a material having the properties of a high thermal conductance, a high melting point and a high latent heat of fusion for release in a selected narrow radiant energy wavelength band to photovoltaic energy converter, efficiently responsive to the selected energy wavelength band.

In conversion of the energy to electrical energy only as much of the energy in a closely controlled form as a photovoltaic cell can convert with high efficiency is released. The energy is captured and stored with minimum loss and is then released at a possibly continuous rate to a photovoltaic cell using a combination of a thermal to radiant energy directional emitter and a band pass filter which together operate to permit only a certain range of photon energies to which a photovoltaic cell can efficiently respond, to be emitted.

The system takes any source of radiant or thermal energy, either continuous or intermittent, at whatever intensity or rate, collects the energy for storage in a material having the three properties in combination of a high thermal conductance, a high melting point and a high latent heat of fusion. Such a material will melt at a constant temperature during the absorption of energy and will freeze at the same constant temperature during the emission of energy. The material serves as a buffer and is provided with efficient thermal encapsulation so that the stored thermal energy can be retained for long periods and the thermal energy can be released at a rate independent of the input.

The storage material has three properties that provide the response and each of those properties has a value that is related to practicability.

The material has a high latent heat of fusion which provides the capability to store large quantities of energy. It thus has a high energy density which provides a large amount of energy storage per unit weight or volume. Further, the smaller volume permits lower energy loss due to a smaller surface area. It has been found that a latent heat of fusion value of above 4.184 kilojoules (1 kilocalorie) per mole is in a useful range.

The material has a high thermal conductance which is a measure of the ability to withdraw the heat that has been stored. It has been found that a thermal conductivity of more than 41.84 watts per metre kelvin (0.1 calories per square centimetre per centimetre per degree per second) is in a useful range.

The material has a high melting point which provides in the molten condition a black body radiation wavelength distribution that is somewhat narrower and more compatible with the responsiveness of the loads which will be using the energy. The melting point should be within a uniform defined range as the temperature is cycled. A melting point as low as 960°C is in a useful range, though above 1027°C is preferred. Some example materials that satisfy the criteria very satisfactorily are iron, silicon and chromium.

In the storage of heat, it has been proposed in US—A—3 596 034 to use any of a large number of materials having high volumetric heat capacity, preferably in the liquid state. The material is inductively heated and cooled by a heat exchange fluid such as water to extract heat. Likewise, in CH—A—102 488, there is disclosed the storage of heat from an unspecified source, for ovens, stoves and similar apparatus, in a storage mass of metal at its melting point. Zinc is suggested, as well as zinc — copper alloys and zinc — lead alloys to give melting points at, above or below 419°C.

The scope of the invention is defined by the appended claims; and how it can be carried into effect is hereinafter particularly described with reference to the accompanying drawings, in which:—

FIG. 1 is a schematic diagram of the elements of an energy conversion system according to the invention;

FIG. 2 is a graph of the broad band wavelength of radiant energy received;

FIG. 3 is a graph, similar to Fig. 2, showing the characteristic black body radiation of the storage material of Fig. 1 and the narrower wavelength band to which a photovoltaic cell is responsive; and

FIG. 4 is a schematic diagram of another energy storage and conversion system for solar-to-electrical energy conversion.

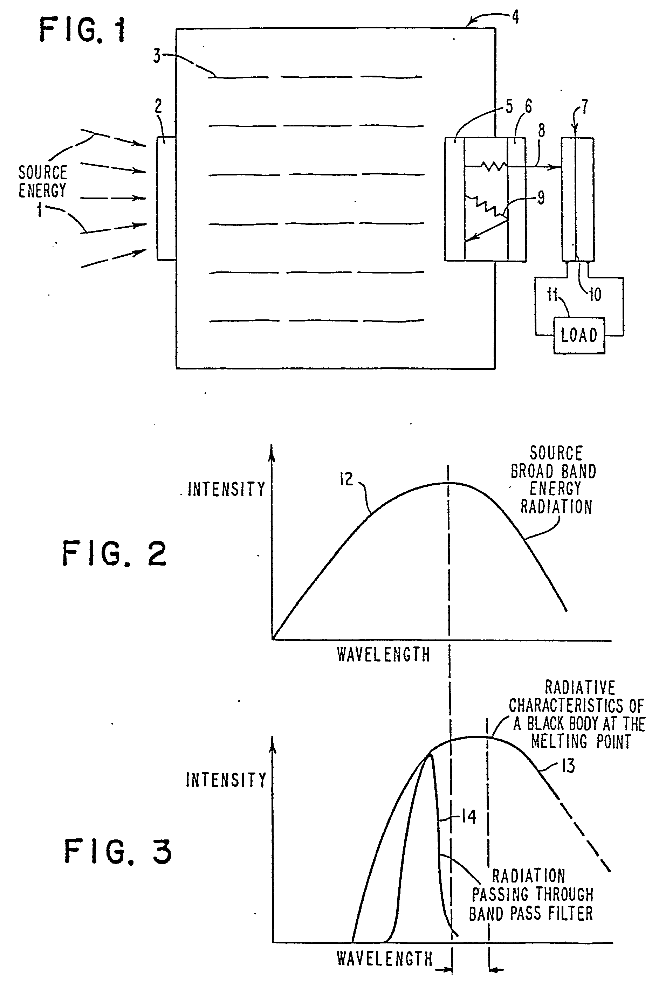

Energy from a source of energy 1 (Fig. 1), such as heat or radiant energy having all or at least a portion thereof as a broad band of wavelengths of radiation 12 (Fig. 2), strikes an absorber 2. The absorber 2 has the property of providing maximum thermal transfer to the storage material 3. In the case of energy 1 in the form of heat the absorber 2 has good thermal conductivity, and in the case of the energy 1 being radiant energy, the absorber 2 provides wavelength independent photo-thermal absorption and may be a broad band photo-thermal converter. The absorber 2 transfers the energy to an energy storage material 3. The absorber 2 in the case of radiant energy may include a concentrator to ensure that the temperature of the input radiation exceeds that of the material 3.

The purpose of the absorber 2 is to extract the maximum amount of energy from the source energy 1 and to transfer it to the storage material 3. It will be apparent to one skilled in the art that, in achieving maximum photo-thermal conversion and heat transfer, such variations as the use of an optical concentrator or modifications in heat exchange sizes may be found advantageous.

The material of the absorber 2 is selected for good energy transfer.

In the case of simple heat, the properties of good thermal conduction accompanied by a melting point higher than the operating temperatures are required. The material tungsten is satisfactory. In the case of radiant energy, in addition to a melting point above the operating temperature, the property of good photothermal conversion for the specifications of the energy source is required. The absorptance, usually identified by the symbol $\alpha$, should be close to 1 for near normal incidence radiation, while the hemispherical emissivity, usually identified in the art by the symbol $\varepsilon$, for all direction other than near normal should be as close to 0 as possible. Such a condition can be approximated in a structure made of refractory metal needles with the needles pointed in the direction of the incident light. One such material is dendritic tungsten, described in the *IBM Journal of Research and Development*, Vol. 22, No. 4, July 1978, p. 372, and in GB—A—1 515 763.

The material 3 is encased in an efficient heat retaining housing 4 to minimize loss. The housing 4 is designed to retain the energy in such a manner that only a portion selected for release is emitted. In the case of conversion to electrical energy the released portion is that which is usable by a particular photovoltaic device at high efficiency while supplying a specific load condition. A directional thermal-to-radiant energy emitter 5 is positioned in an opening in the housing 4 and is optically coupled to a radiant energy band pass filter 6. The emitter 5 and filter 6 are positioned for good optical coupling to a photovoltaic device 7. The emitter 5, filter 6 and device 7 have interdependent properties such that the directional emitter 5 converts the thermal energy stored in the material 3 into radiant energy sufficiently directionally in a general sense that the band pass filter 6 can then permit only certain photons, the energy range of which is governed by the responsiveness of the photovoltaic device 7, to pass (as indicated by the arrow 8), while rejecting and turning back all other photons (as indicated by the arrow 9). This structure provides a controlled release such that only the energy that can be efficiently used by a photovoltaic device 7 is permitted to escape and the storage material 3 continues to retain all unused energy. The photovoltaic device 7 has a photovoltaic junction 10 across which a load 11 is connected.

The storage material 3 will melt at a constant temperature when the rate of absorption of energy through the absorber 2 is greater than the rate of emission of energy from the storage material 3 out of the opening in the container 4. Conversely the material 3 will solidify at the same constant temperature when the rate of emission is greater than the rate of absorption.

The interdependent properties of the emitter 5, the filter 6 and the photovoltaic cell 7 are selected so that, while the source of the energy stored may vary in intensity and be intermittent, the energy that is emitted is steady and is optimized with respect to the performance of the photovoltaic device 7 and to the load 11.

The material of the storage material 3 has the properties of high thermal conductance, high latent heat of fusion and high melting point. For good electrical conversion at the melting, about 10% of the black body radiation in the high photo energy portion will be absorbed by the photovoltaic cell 7. High melting point metals will satisfy these conditions quite well. The element iron Fe is particularly satisfactory having a melting temperature of 1536°C, a latent heat of fusion of 15.355 kilojoules (3.67 kilocalories) per gram atom and a thermal conductivity of 75.3 watts per metre Kelvin (0.18 calories/cm²/cm²/degree/second). A gram atom of Fe is 55.8 grams.

Another material is the element silicon Si with a melting temperature of 1410°C, a latent heat of fusion of 46.44 kilojoules (11.1 kilocalories) per gram atom and a thermal conductivity of 83.68 watts per metre Kelvin (0.2 calories/cm²/cm/degree/second). A gram atom of Si is 28.1 grams.

Another material is chromium with a melting temperature of 1510°C, a latent heat of fusion of more than 4.184 kilojoules (1 kilocalorie) per gram atom and a thermal conductivity of more than 41.84 watts per metre Kelvin (0.1 calories/cm²/cm/degree/second). A gram atom of chromium is 52.0 grams.

Yet another material is silver which has a very high thermal conductivity of 418.4 watts per metre Kelvin (1 calorie per cm² per cm per degree per second), a latent heat of fusion of 11.2968 kilojoules (2.7 kilocalories) per mole and a melting temperature of 960°C.

The housing 4 in which the storage material 3 is encased has the properties of low coefficient of heat transfer and low emissivity so that there is maximum retention of heat. Because high melting point metals may involve temperatures above 1800°C, the materials of the housing 4 may be of a refractory type, such as boron nitride or aluminium oxide and may, in turn be further surrounded by a reflective evacuated chamber (not shown). As the object is to retain all transmitted energy within the housing 4, except that which is permitted to escape through controlled conditions produced by the interdependent properties of emitter 5, filter 6 and defice 7, it will be apparent that the thermal retention properties of housing 4 are important to the efficiency of the system.

The overall structure operates in combination to provide a closer energy matching by, in a first stage, absorbing the broad band energy radiation 12 (Fig. 2), and, as the material 3 reaches the molten stage, converting the radiative characteristics to a different distribution 13 (Fig. 3). The distribution 13 has a peak wavelength that is greater than that of radiation 12, and the distribution 13 is offset, as shown by the separation of the dotted lines approximating the centres of radiation 12 and distribution 13. In a second stage, the structure of emitter 5 and filter 6 only permit release of a narrow band of the distribution, as shown by the curve 14 (Fig. 3), whose centre is located to correspond with the responsiveness of the photovoltaic device 7. By selection of the emitter 5 and filter 6, the width of the narrow band 14 can be adjusted, as well as the location and height of the peak, within the distribution 13.

While radiation will take place from the material 3 when energy is stored in it both below and above the melting temperature, the most advantageous situation occurs at the melting temperature, where all the latent heat of fusion can be stored at constant temperature until all the material 3 is molten and all the latent heat of fusion can be released at constant temperature until the material 3 is solid. The material 3 radiates with the characteristics of the distribution 13 at a constant temperature.

Where the stored thermal energy in the material 3 is to be transferred as thermal energy to a heat using load, an opening such as that occupied by emitter 5 and filter 6 in the housing 4 would be fitted with a thermal converter. The ability to store energy from either radiant or thermal sources independent of intensity or duration, and the storage of energy in a material having high energy density, due to high latent heat of fusion, ease of energy removal, due to the high thermal conductance, and the predictable heat characteristic, due to the melting point, operate to provide a more efficient system than has been proposed heretofore in the art. The size is smaller, the heat can be transferred out more readily and the converter that uses the heat can be more efficiently designed because the heat is available under narrower specifications.

Where the source energy 1 is of an intermittent character, such as solar energy, the efficiency of the housing 4 may be enhanced by the provision of a device, such as a heat mirror (not shown in Fig. 1), which can be operated to block the input opening substantially to prevent radiation loss from the opening and thereby loss of energy. In the radiant energy type of application, this would occur as the strength of the radiant energy becomes lower than that of the energy radiated by the absorber 2 which is thermally coupled to the storage material 3, such as may occur in solar applications with the approach of and during night. In a similar way, where an off-duty cycle is desired, that is no electrical output is required at certain times, the output opening may be blocked by a similar device substantially to prevent radiation loss from the opening.

In a type of application where the invention is used as a portable power supply for a vehicle or as a standby power supply for a piece of equipment, once an adequate energy storage for the purpose is complete, e.g. when all the material 3 is molten, the housing 4 can be closed, except for occasional opening of the output, and only energy lost need be periodically replaced.

The energy, once it is stored in the material 3, is controllably released by emission and it is further only of that portion of the wavelength band (Fig. 3) to which the photovoltaic device is able to respond with efficiency.

The efficiency of such photovoltaic devices can be further enhanced by narrowing the emission until the photon energy is just greater than the band gap energy of the material of the photovoltaic device. With this approach, efficiencies over 50% are achievable in contrast to the maximum at the present of about 26%.

Accordingly, a narrow band of photon energies, just above the energy band gap of the photovoltaic cell 7, is selected for release by an interdependent combination of the directional thermal-to-radiant energy emitter 5, the band pass filter 6 and the photovoltaic cell 7 which are arranged so that the emitter 5 converts the thermal energy to radiant energy with some direction, then only those photons, shown by the arrow 8, which are at the peak responsiveness wavelength of the photovoltaic cell 7 are permitted to pass through the filter 6 and all others, shown by the arrow 9, are returned and re-absorbed by the emitter 5 and thus do not contribute to heat loss.

The thermal-to-radiant energy emitter 5, to be directional, should have the property that the total hemispherical emissivity, usually identified in the art by the symbol $\varepsilon$, is at a value of nearly 1 in a direction normal to the surface and is at a value nearly 0 for all other directions. An example of a suitable material is dendritic tungsten, as described in the *IBM Journal of Research and Development*, Vol. 22, No. 4, July 1978, p. 372, with the needles pointed in the direction of emission.

Band pass filters of the type required for band pass filter 6 are known in the art and are commercially available. Such filters have the property that if a wide band of radiation is normally incident thereon, only a small preselected range of wavelengths will be transmitted, while the remaining radiation will be reflected. Where the material 3 is molten iron at about 1536°C and the photovoltaic cell 7 is silicon, then the band pass filter 6 is designed to transmit and thereby release photons having an energy range 1.1 to 1.6 electron volts and to reflect all others shown back into the material 3.

One group of band pass filters known in the art have been made up of multiple dichroic layers. The layers are dielectric, each with a different index of refraction that in combination provide transparency only in a narrow range. Dielectric materials $SiO_2$, $ZnO$, $Al_2O_3$, $Si_3N_4$, and $TaO$ are usable. Another type of filter uses a semiconductor window with a band energy gap of the appropriate value together with proper reflectors. The filter 6 would permit only those photons having energies in the maximum energy response range of the photovoltaic device 7 to pass, and photons not emitted in a straight line from the emitter 5 are reflected back and are retained inside the container and thus do not contribute to energy loss.

Positioned with good optical coupling to the filter 6 is an efficient photovoltaic converter 7 such as the V-groove multijunction silicon solar cell described in *The IEEE Transactions on Electron Devices*, Vol. ED—26, July 1979, pp. 1090 to 1097. The selection of the photovoltaic cell 7 is affected by the melting temperature of material 3, the energy band gap of the material of the photovoltaic cell 7 and the directionality and narrowness of the band of photo energies 8 that emanate from the combination of the emitter 5 and the band pass filter 6.

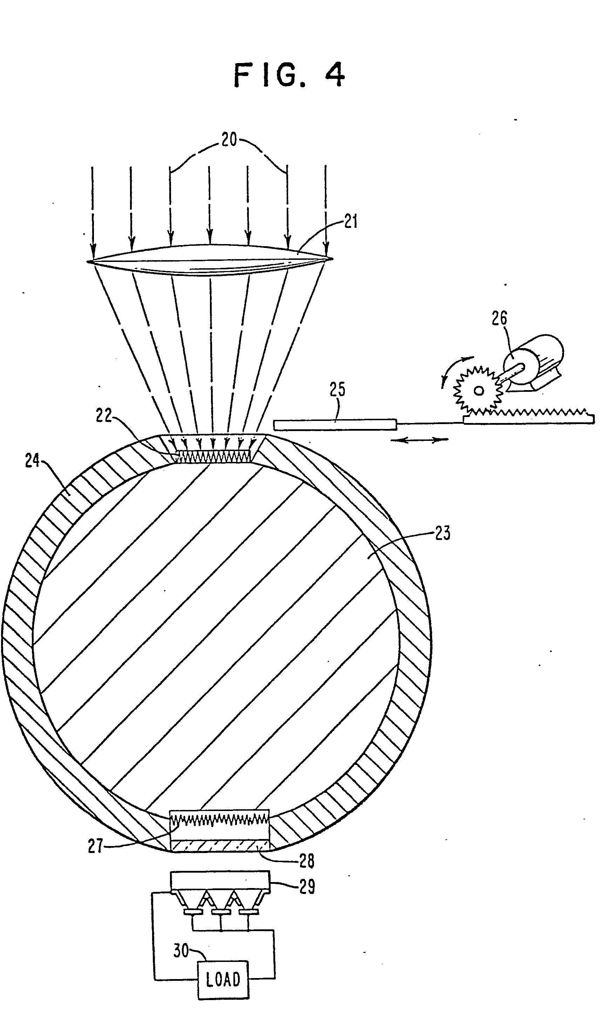

In an embodiment of a system of energy storage for the conversion of the daily energy of the sun into continuous electrical power (Fig. 4), solar energy 20 is provided through a concentrator lens 21 which focuses, at a concentration ratio of approximately 500 to 2000 times onto an absorber 22 having properties such that the absorptance, usually identified in the art by the symbol $\varepsilon$, is at a value of 1 and the hemispherical emissivity, usually identified in the art by the symbol $\varepsilon$, is at a value of equal to or less than 0.2. The absorber 22 provides transfer of the radiant energy 20 into a thermal energy in storage material 23.

The material dendritic tungsten with the needles towards the source of radiant energy satisfies the band criteria for the absorber 22.

A heat insulating container 24 for the storage material 23 is spherical because the spherical shape gives minimum surface area to volume and hence minimum area to insulate.

The energy storage material 23 is positioned in the container 24 and has the properties of having a high latent heat of fusion, a high thermal conductance and a high melting temperature at which about 10% of the black body radiation thereof will be in the high photon energy range absorbable by a photovoltaic cell. The materials iron and silicon each satisfy these properties.

There is an opening in the container 24 for the absorber 22 and a cover 25 is provided to prevent radiation out of the opening when radiant energy ceases to be received, as when the sun goes down. The cover 25 is a heat mirror movable by a motor and gear apparatus 26 to cover and uncover the opening.

When the sun goes down or when the receipt of energy by the storage material should be interrupted, the apparatus 26 moves the mirror 25 over the opening.

For simplicity, the container 24 is shown as of a single material such as, for example, boron nitride or aluminium oxide, the properties of which are good heat insulation and a low emissivity. In fact, however, the higher the retention properties of the container 24, the greater will be the efficiency of the entire system so that the container 24 may be further surrounded with an evacuated container or other structure. Accommodation may also be necessary for pressure change and expansion. This would be of particular importance if the material 23 were to be operated using the property of the latent heat of vaporization. The preferred type of operation employs the latent heat of melting because of the radiative characteristic advantages. The energy stored by melting the storage material 23 is selectively let out through an emitter 27 and filter 28 during freezing of the material 23 at the maximum efficiency of a photovoltaic cell 29 and for maximum use in an electrical load 30.

There is an opening in the container 24 for the emitter 27 and filter 28 which may be covered by an arrangement similar to the cover 25 and apparatus 26.

When the sun is the source of radiant energy, the amount of material 23 that will be needed will depend on the energy density impinging on absorber 22 during available time, the day, and the electrical energy to be continuously or cumulatively delivered to the load 30. The quantity of material 23 is chosen so that for the worst anticipated night the material 23 would be almost entirely frozen at dawn, whereas for the best anticipated day it would be almost entirely molten at dusk.

The material 23 in the system preferably uses the latent heat of fusion and remains at a constant melting point temperature. The relative fraction that is molten will depend upon the cumulative energy received minus the energy that is delivered or lost. Appropriate safety factors for variations in supply and load should be included. The quantity of material 23 should be sufficient that it is never completely molten. The system is then prevented from overheating and thereby being damaged if not designed for it. Were the latent heat of vaporization to be employed, the available heat storage capacity is greater, but structural designs to handle pressures and temperatures must be modified.

The controlled energy release structure made up of the combination of the photovoltaic cell, the band pass filter and the directional thermal to radiant energy may be assembled as an aligned stack for good optical coupling and minimum loss, but high thermal temperatures should be kept from the photovoltaic device 29 because of the temperature effect on semiconductor performance and specifications regarding heat on any dichroic material in the filter 28 should not be exceeded.

The photovoltaic converter 29 should have a maximum efficiency response that is tailored to the energy of the photons coming out of the band pass filter 28. A V-groove solar cell uses silicon that responds to photons having an energy from 1.1 to 1.6 electron volts. It involves multiple internal reflections and provides very high efficiency. Under conditions where the properties of emitter 27 and filter 28 are such that only photons in the responsive range are transmitted, the V-groove multijunction solar cell is expected to convert at an efficiency greater than 50% and that the total conversion efficiency of the storage system will be in the vicinity of 40%.

The material 23 will remain continuously at the melting temperature whether the amount of heat coming in is exceeding that released and the molten portion is increasing or the opposite condition where more heat is being released than is coming in and the molten portion is decreasing.

The following examples are an illustration of system performance using as an assumption in a solar energy application an eight hour average daily sunlight and using a 1-square metre concentrator lens 21 which provides 1 kilowatt impinging on absorber 22 for 8 hours which provides 8 kilowatts per day. Where the material 23 is iron (Fe), with a melting temperature (Tm) of 1536°C, an atomic weight of 55.8 grams/cc, a density ($\rho$) of 7.87 gms/cc, a latent heat of fusion ($\Delta H_f$) of 15.355 kilojoules (3.67 kilocalories)/mole and a thermal conductivity of 75.3 watts per metre Kelvin (0.18 calories/cm²/cm/degree/second), then for 8 kilowatt hours of storage there will be required 106 kilogrammes (233 lbs), occupying a volume of 13.5 litres which in turn requires a containment sphere of 14.7 centimetre radius.

Where the material is silicon (Si) with a melting temperature (Tm) of 1410°C, an atomic weight of 28.1, a density ($\rho$) of 2.35 gms/cc, a latent heat of fusion ($\Delta H_f$) of 46.44 kilojoules (11.1 kilocalories) per mole and a thermal conductivity of 83.68 watts per metre Kelvin (0.2 calories/cm²/cm/degree/second), then for 8 hours of storage there will be required 14.7 litres which in turn requires a containment sphere of 12.0 centimetres radius.

The 8Kw energy stored in the 14.7 or 12.0 cm radius sphere of Fe or Si, respectively, at an assumed temperature of 1536°C or 1410°C is selectively released as photons with an energy that is in the responsive range of a photovoltaic cell through the use of the thermal-to-radiant energy emitter 27 and band pass filter 28. This type of energy transfer can be approximated in practice by using dendritic tungsten with the needles in the direction of emission as the emitter 27 positioned in a tandem arrangement with a band pass filter 28 made up of an intrinsic semiconductor window with a band gap energy corresponding to the desired high photon energy cutoff of responsiveness of the photovoltaic device 29 that is coated with a transparent reflective layer such as a dielectric oxide and a heat mirror such as glass coated with a conductive oxide such as tin oxide. The reflective layer on the semiconductor window and the heat mirror in combination operate to reflect photons that have either too high or too low an energy to be passed by the semiconductor window. For a photovoltaic device 29 with peak efficiency responsiveness to photons in the 1.1 to 1.6 electron volt range, the semiconductor window could be a cadmium telluride (CdTe) crystal 127$\mu$ (50 mil) thick or a hydrogenated amorphous silicon layer ($\alpha$-Si:H) 254$\mu$m (10 mil) thick, coated with 1300 to 1600 Å of $SiO_2$ or $TiO^2$ in tandem with and preceded by a heat mirror of SnO coated glass.

An emitter 27 of dendritic tungsten at 1536°C would be emitting 75 watts/cm$^2$ with a hemispherical emissivity of 1, but with an assumed average emissivity of 0.2 it would emit 15 watts/cm$^2$. Assuming the area of the emitter 27 to be 200 cm$^2$ there will be 3000 watts emitted and the band pass filter 28 will reflect 2700 watts that do not have the correct range of photon energy. The 300 watts that are passed represent 7.2 Kwh over 24 hours or a loss of 0.8 Kwh in the storage portion of the system. The 300 watts are converted in the V-groove multijunction photovoltaic device 29 at a 50% efficiency providing a 3.6 Kwh over a 24 hour day. Thus, a sphere approximately 254 mm (10 inches) in diameter will store in 8 hours enough energy to supply a 373 watt (1/2 horsepower) motor for 24 hours with approximately a light input through a concentrator 100 cm on a side and a photovoltaic device output that is about 14 cm on a side.

In a situation where there is a variable electrical load connected to cell 29, some energy efficiency accommodation an be provided with an optical imaging system with a reflective diaphragm interposed between filter 28 and cell 29 to recycle excess photons during low demand periods. Alternatively, electrical power could be fed back into material 23 from cell 29 resistively as heat in low demand load periods or the opening could be controlled through an arrangement similar to cover 25 and apparatus 26.

What has been described is a system of buffering and converting energy so as to provide for radiant energy input of variable density and duration and electrical energy output of selectable duration and intensity.

## Claims

1. A radiant energy conversion system comprising a thermally insulated energy storage container (4; 24), energy storage material (3; 23) within the container, energy input means (2; 22) and energy output means (H 5, 6, 7; 27, 28, 29), characterised in that the energy storage material has a thermal conductivity of more than 41.84 watts per metre Kelvin (0.1 calories/cm$^2$/cm/°C/sec), a latent heat of fusion of more than 4.184 kilojoules (1 kilocalorie) per mole, and a melting point of not less than 960°C, and that the energy output means includes a thermal to selected narrow radiant energy wavelength band converter (5, 6; 27, 28), which is optically coupled to a photovoltaic converter (7, 29) efficiently responsive to the selected energy wavelength band.

2. A system according to claim 1, in which the thermal to selected narrow radiant energy wavelength band converter includes a thermal to radiant energy emitter (5; 27) optically coupled to a selected photon energy transmitting member (6; 28).

3. A system according to claim 2, in which the emitter is dendritic tungsten.

4. A system according to claim 3, in which the dendritic tungsten has the needles directed away from the source of thermal energy.

5. A system according to claim 2, 3 or 4, in which the transmitting member is a band pass filter.

6. A system according to claim 5, in which the filter is a 1.1 to 1.6 electron volt photon band pass filter.

7. A system according to claim 2, 3 or 4, in which the transmitting member is a selected photon energy passing semiconductor window with associated non-selected energy reflecting members.

8. A system according to any preceding claim, in which the photovoltaic converter includes a V-groove multijunction solar cell (29) optically coupled to the band pass filter.

9. A system according to any preceding claim, in which the melting point of the energy storage material (3, 23) is above 1027°C.

10. A system according to claim 9, in which the energy storage material is iron, silicon, or chromium.

11. A system according to any preceding claim, in which the energy input means includes a radiant-to-thermal energy converter.

12. A system according to claim 11, in which the converter is dendritic tungsten (22).

13. A system according to claim 12, in which the dendritic tungsten has the needles in the direction of the sources of radiant energy.

## Revendications

1. Système de conversion d'énergie de rayonnement, comportant un conteneur calorifugé de stockage de l'énergie (4; 24), un matériau de stockage de l'énergie (3; 33) situé à l'intérieur du conteneur, des moyens d'entrée de l'énergie (2; 22) et des moyens de sortie de l'énergie (5, 6, 7; 27, 28, 29), caractérisé en ce que le matériau de stockage de l'énergie possède une conductibilité thermique supérieure à 41, 81 watts par mètre Kelvin (0,1 calorie/cm²/cm/°C/s), une chaleur latente de fusion supérieure à 4,184 kilojoules (1 kilocalorie) par mole, et un point de fusion non inférieur à 960°C, et que les moyens de sortie de l'énergie comprennent un convertisseur de bande de longueurs d'onde d'énergie thermique en une bande étroite sélectionnée de longueurs d'ondes d'énergie de rayonnement (5, 6; 27, 28), qui est accouplé optiquement á un convertisseur photovoltaïque (7, 29) répondant de façon efficace à la bande sélectionnée de longueurs d'ondes d'énergie.

2. Système selon la revendication 1, dans lequel le convertisseur de bande de longueurs d'onde d'énergie thermique en une bande étroite sélectionnée de longueurs d'onde d'énergie de rayonnement comporte un émetteur (5; 27) transformant l'énergie thermique en une énergie de rayonnement et accouplé optiquement à un organe (6; 28) transmettant l'énergie photonique sélectionnée.

3. Système selon la revendication 1, dans lequel l'émetteur est du tungstène dendritique.

4. Système selon la revendication 3, dans lequel les aiguilles du tungstène dendritique sont dirigées à l'opposé de la source d'énergie thermique.

5. Système selon la revendication 2, 3 ou 4, dans lequel l'organe de transmission est un filtre passe-bande.

6. Système selon la revendication 5, dans lequel le filtre est un filtre passe-bande pour des photons de 1,1 à 1,6 électronvolt.

7. Système selon la revendication 2, 3 ou 4, dans lequel l'organe de transmission est une fenêtre à semiconducteurs de transmission de l'énergie photonique sélectionnée, comportant des organes associés réfléchissant l'énergie non sélectionnée.

8. Système selon l'une quelconque des revendications précédentes, dans lequel le convertisseur photovoltaïque comporte une pile solaire (29) à jonctions multiples à gorges en V, accouplée optiquement au filtre passe-bande.

9. Système selon l'une quelconque des revendications précédentes, dans lequel le point de fusion du matériau de stockage de l'énergie (2, 23) est supérieur à 1027°C.

10. Système selon la revendication 9, dans lequel le matériau de stockage de l'énergie est du fer, du silicium ou du chrome.

11. Système selon l'une quelconque des revendications précédentes, dans lequel les moyens d'entrée de l'énergie comprennent un convertisseur d'énergie de rayonnement en énergie thermique.

12. Système selon la revendication 11, dans lequel le convertisseur est du tungstène dendritique (22).

13. Système selon la revendication 12, dans lequel les aiguilles du tungstène dendritique sont dirigées vers la source d'énergie de rayonnement.

## Patentansprüche

1. Einrichtung zur Umwandlung von Strahlungsenergie, mit einem wärmeisolierten Energiespeicherbehälter (4; 24), einem Energiespeicherstoff (3; 23) im Behälter, Energieeingabemitteln (2; 22) und Energieausgabemitteln (5, 6, 7; 27, 28, 29), dadurch gekennzeichnet, daß der Energiespeicherstoff eine thermische Leitfähigkeit von mehr als 41, 84 Watt pro Meter und Kelvin (0,1 Kalorien/cm²/cm/°C/s), eine latente Schmelzwärme von mehr als 4,184 Kilojoule (1 Kilokalorie) pro Mol, und einen Schmelzpunkt von weniger als 960°C hat, und daß die Energieausgabemittel einen Wandler (5, 6; 27, 28) zur Umwandlung thermischer in Strahlungsenergie eines ausgewählten schmalen Wellenlängenbandes enthält, welcher mit einem photoelektrischen Wandler (7 29) optisch gekoppelt ist, der auf das ausgewählte Energiewällenlängenband wirksam anspricht.

2. Einrichtung nach Anspruch 1, bei welcher der Wandler zur Umwandlung thermischer in Strahlungsenergie eines ausgewählten schmalen Wellenlängenbandes einen Wärmeenergie-auf-Strahlungsenergie-Emitter (5; 27) enthält, der mit einem Durchlaßelement (6; 28) für eine ausgewählte Photonenenergie optisch gekoppelt ist.

3. Einrichtung nach Anspruch 2, bei welcher der Emitter dendritisches Wolfram ist.

4. Einrichtung nach Anspruch 3, bei welcher das dendritische Wolfram die Nadeln von der Wärmeenergiequelle weggerichtet hat.

5. Einrichtung nach Anspruch 2, 3 oder 4, bei welcher das Durchlaßelement ein Bandpaßfilter ist.

6. Einrichtung nach Anspruch 5, bei welcher das Filter ein Bandpaßfilter für Photonen von 1,1 bis 1,6 Elektronvolt ist.

7. Einrichtung nach Anspruch 2, 3 oder 4, bei welcher das Durchlaßelement ein eine ausgewählte Photonenenergie durchlassendes Halbleiterfenster mit zugehörigen Reflexionselementen für icht-ausgewählte Energie ist.

8. Einrichtung irgendeinem vorstehenden Anspruch, bei welcher der photoelektrische Wandler eine mit dem Bandpaßfilter optisch gekoppelte V-Nut-Mehrfachübergangs-Solarzelle (29) enthält.

9. Einrichtung nach irgendeinem vorstehenden Anspruch, bei welcher der Schmelzpunkt des Energiespeicherstoffes (3, 23) oberhalb 1027°C liegt.

10. Einrichtung nach Anspruch 9, bei welcher der Energiespeicherstoff Eisen, Silizium oder Chrom ist.

11. Einrichtung nach irgendeinem vorstehenden Anspruch, bei welcher die Energie-eingabemittel einen Strahlungs-/Wärme-energiewandler enthalten.

12. Einrichtung nach Anspruch 11, bei welcher der Wandler dendritisches Wolfram (22) ist.

13. Einrichtung nach Anspruch 12, bei welcher das dendritische Wolfram die Nadeln in Richtung der Strahlungsenergiequelle hat.

FIG. 1

SOURCE
ENERGY
1

LOAD

FIG. 2

INTENSITY

12

SOURCE
BROAD BAND
ENERGY
RADIATION

WAVELENGTH

FIG. 3

INTENSITY

RADIATIVE
CHARACTERISTICS OF
A BLACK BODY AT THE
MELTING POINT

13

14

RADIATION
PASSING THROUGH
BAND PASS FILTER

WAVELENGTH

# FIG. 4